# EUROPEAN PATENT SPECIFICATION

(11) **EP 3 642 384 B1**
(45) Date of publication and mention of the grant of the patent: **15.04.2026**
(21) Application number: 18841667.1
(22) Date of filing: 31.07.2018
(51) Int. Cl.: H01L 21/20, B23K 26/08, B23K 26/082, B23K 26/352, C23C 14/58, C23C 16/56, H01S 3/10, B23K 26/073

(54) **LASER APPARATUS AND METHOD OF PROCESSING THIN FILMS**
LASERVORRICHTUNG UND VERFAHREN ZUR BEARBEITUNG VON DÜNNSCHICHTEN
APPAREIL LASER ET PROCÉDÉ DE TRAITEMENT DE FILMS MINCES

(30) Priority: 31.07.2017 US 201762539183 P; 23.08.2017 US 201762549254 P
(43) Date of publication of application: 29.04.2020
(73) Proprietor: IPG Photonics Corporation, Marlborough, MA 01752 (US)
(72) Inventor: LIMANOV, Alexander, Oxford MA 01540 (US); VON DADELSZEN, Michael, Oxford MA 01540 (US); SCHOENLY, Joshua, Oxford MA 01540 (US); LEONARDO, Manuel, Oxford MA 01540 (US)
(74) Representative: Kobiako von Gamm, Iouri
(86) International application number: PCT/US2018/044705
(87) International publication number: WO 2019/028082

(56) References cited:
- EP-A2- 1 553 643
- WO-A1-2010/130415
- WO-A1-2017/004280
- CN-U- 202 183 771
- KR-A- 20140 070 725
- TW-A- 200 730 807

## Description

### BACKGROUND OF THE DISCLOSURE

### Field of the disclosure

This disclosure relates to a laser method of two-dimensional (2D) processing of a thin film deposited on a glass panel sized to be orders of magnitude larger than a laser beam. The disclosure is further related to a fiber laser which in combination with a homogenizer implements the disclosed process.

### Prior Art

One of the currently popular methods for producing glass panel displays utilizes an excimer laser low-temperature polycrystalline silicon (LTPS) annealing process that is well known to one of ordinary skill in the display arts. In production of LTPS systems, the rectangular output of the pulsed excimer laser is significantly reshaped into a long, thin line beam typically having a length equal to the width, or half the width, of the panel. Excimer lasers used for excimer laser annealing (ELA) processes have a high energy per pulse with a low repetition rate. This makes them suitable for single line annealing of large panels, wherein the line beam encompasses the entire panel width or at least half the width. This enables the entire panel to be processed in one or two passes under the laser.

However, with KHz frequencies leading to high energies, excimer lasers, which by themselves are very expensive and cumbersome, require multiple gas changes over approximately 48 hours day-long period of operation, which also makes them expensive to operate. This and other necessary attributes of excimer lasers render them rather inefficient and make the overall cost of owning and operating excimer sources very high.

The above disadvantages of excimer lasers led up to a widespread use of fiber lasers operating in continuous wave (CW), quasi CW (QCW) burst mode regimes, with the latter characterized by two different repetition rates for bursts (characterized by a burst repetition rate (BRR) or a burst repetition frequency (BRF)) - which are relatively long pulses - and for pulses (carrier pulse repetition rate (PRR)) within each burst. As is well known, fiber lasers are highly efficient, substantially maintenance-free and low cost rugged light sources.

The fiber lasers used in the LTPS systems are disclosed, for example, in WO 2017/120584 disclosing QCW, pulsed and even CW fiber lasers for spot beam crystallization of a-Si films. The disclosed system in WO 2017/120584 is applicable to small-size panels that can be fully covered in one direction by a laser beam scanned across the entire film. In particular, a molten zone created on the film is translated in the scanning direction progressively heating each subsequent region across the entire width of the substrate.

QCW fiber lasers in general, including burst mode fiber lasers with configured to output a total power output that is equivalent to an excimer laser source, however, have orders of magnitude lower pulse energies and requisite orders of magnitude higher repetition rates. The pulse energy is too low to allow for a line beam from a single fiber laser to encompass the entire panel if its width is greater than the length of the line beam.

For this reason, it is necessary to stitch together partial line beams in the line beam's long axis/scanning direction, as disclosed in WO 2017/004280, such that the resultant poly-Si grain structure is continuous over the region of interest greater than the beam's length. The latter may be the entire panel area, or portions thereof.

Stitching together two adjacent lines in the long beam axis provides significant challenges not encountered by WO 2017/120584, but acknowledged in US 2016/013057. Ideally, each line beam will have a perfectly sharp edge and the edges of adjacent beams will exactly abut. This is not physically realizable due to diffraction limited point spread function sharpness of the line beam edge and limitations in mechanical accuracy. For instance, the ends of the line beams will always have some softness of definition. There are a few possibilities of stitching, but regardless of however the beams are stitched, it is very likely that there will be some artifacts at the seams between adjacent beams that will result in some discontinuity of p-Si grain structure and eventually in poor quality of the annealed panel.

Furthermore, beam stitching is accompanied by the formation of Mura, a phenomenon observed on laser treated substrates that is characterized by low contrast and non-uniform brightness. and can give a "rippled" appearance to the laser treated substrates. The Mura is unacceptable and considered a defect since the quality of the p-Si substrates is poor.

A need therefore exists for a method of processing large thin film areas on a substrate panel using a fiber laser line beam, which is much smaller than the thin film area Af, such that no stitching of adjacent beams is needed.

Another need exists for a fiber laser, which is configured with a homogenizer, implementing the disclosed method.

### SUMMARY OF THE DISCLOSURE

The inventive method, meeting the above disclosed needs, is applied to a variety of applications including, without any limitation, Fiber Laser Annealing (FLA) amorphous Si annealing, Sequential Lateral Solidification (SLS) amorphous Si annealing, Doping Impurity Activation, Silicon Carbide (SiC) annealing (e.g., ohmic contacts), and polyimide Laser Lift Off (LLO) applications. The disclosed method eliminates stitching by providing the overlap between adjacent irradiated thin film areas, further referred to as columns, in the second direction X, whereas each column is formed by irradiating film areas in the first direction Y. By controllably varying a distance dx between the columns and a distance *dy* between the adjacent irradiated areas within each column, the desired cumulative exposure duration od/number of pulses per each irradiated location of the film area Af and temperature are achieved. Hence the disclosed method is further referred to as the 2D process.

In particular, the disclosed 2D method of fiber processing a thin film is implemented by using a QCW fiber laser that operates in the burst regime, outputting a laser beam at a high repetition carrier pulse rate (PRR) which is preferably higher than 100 KHz and can be as as high as 1 GHz. The laser beam propagates along a path through an optical beam shaping unit. The shaped beam -a line beam - is then incident on the film, thereby forming a first irradiated thin film area Ab on the film's surface.

Thereafter, the shaped laser beam and the substrate are displaced, continuously, relative to one another in a first direction Y at a distance *dy*, which is smaller, greater than, or equal to a width of the irradiated thin film area Ab. Accordingly, the adjacent irradiated areas Ab may overlap one another, be adjacent to, or spaced apart from one another in the first direction Y. As result, an elongated column formed on the film is defined by a sequence of uniformly irradiated thin film areas Ab.

The completion of the column, which has a width corresponding to the length of the line beam, is followed by displacing the thin film and the beam shaping unit in the second, scanning direction X at a distance *dx*. The distance dx is selected to be shorter than the width of the previously formed column. Hence the columns are overlapped in the second direction which eliminates the need for subsequent stitching of the adjacent columns.

The process continues until the desired part of the film area Af or the entire film area Af is processed. The processed film thus has each location thereof exposed to the shaped laser beam for the predetermined cumulative duration/number of bursts, and the irradiated area Af of the thin film is characterized by a uniform fluence. As a consequence, the irradiated film area Af has the desired microstructure or other properties, e.g., surface sheet resistance, or contact resistance.

The disclosed fiber laser system implementing the method is configured with a multi-axis stage supporting the thin film area Af to be irradiated. At least one fiber laser source outputs a laser beam processed in an optical beam shaping unit. The latter is configured to shape the laser beam into a line beam which has desired geometrical dimensions, intensity profile, and an optimal power to form a first irradiated thin film area Ab which is a fraction of the total thin film area Af. Processing the thin film area Af in accordance with the inventive 2D method is controlled by a processor such that adjacent columns overlap one another in the second x direction and individual irradiated film areas Ab of each column overlap one another in the first y direction. The dx and dy distances are so selected that each location of the processed total or part of film area Af is exposed to the shaped beam a predetermined number of times, i.e., irradiated during the desired exposure duration, and has a predetermined temperature.

The inventive fiber laser system is structured using a burst mode QCW fiber laser in combination with a homogenizer such as imaging or non-imaging fly's eye, bi-prisms, or any other known configurations associated with segmenting the laser beam. In accordance with a salient feature of this embodiment, a plurality of delay glass pairs are incorporated in the homogenizer and configured to correct manufacturing tolerances of the homogenizer's components. In particular, each delay glass pair includes two lenses rotatable and linearly displaceable relative to one another in orthogonal planes so as to focus multiple beamlets in a common focal plane on the surface of the film thus shaping the laser beam into a narrow line beam which has a width ranging between 3 and 50 µm and a length between 1 and 10 cm.

Numerous features of the disclosed system and method can be used interchangeably as will become more apparent from dependent claims reciting respective features.

However, the present invention is defined by the appended claims.

### BRIEF DESCRIPTION OF THE DRAWINGS

The above and other aspects and features, which can be used partially or in any combination in the inventive method and apparatus, will become more readily apparent from the following drawings, in which:
FIG. 1 is a flow chart representing the inventive method;
FIGs. 2A - 2B are a schematic representations of a thin film area Af processed in accordance with the invention;
FIG. 3 is a multi-beamlet imaging fly's eye homogenizer and cross-axis objectivelens;
FIGs. 4 and 5 illustrate respective views of the homogenizer;
FIGs. 6A, 6B, 7A, 7B, 8A and 8B illustrate possible manufacturing defects of optical components;
FIGs. 9A and 9B illustrate respective side and isometric views of the inventive delay glass pair; and
FIGs. 10 and 10B are respective side and top views of the optical schematic of the homogenizer.

### SPECIFIC DESCRIPTION

Reference will now be made in detail to the disclosed system. Wherever possible, same or similar reference numerals are used in the drawings and the description to refer to the same or like parts or steps. The drawings are in simplified form being far from precise scale. For purposes of convenience and clarity only, the terms "connect," "couple," and similar terms with their inflectional morphemes do not necessarily denote direct and immediate connections, but also include connections through mediate elements or devices.

The disclosed method utilizes a CW or QCW burst laser beam for processing thin films. The disclosed method is specifically tailored to process a thin film area Af which is orders of magnitude larger than an individual or partial film area Ab irradiated by the line beam. In contrast to known conventional techniques, no stitching of successive partial irradiated film areas Ab in first y and second x orthogonal directions is needed. The methodology described in the disclosure can be used for applications including, but not limited to: FLA (ELA equivalent) amorphous Si annealing, SLS amorphous Si annealing, SiC annealing (e.g. ohmic contacts), and Polyimide LLO applications.

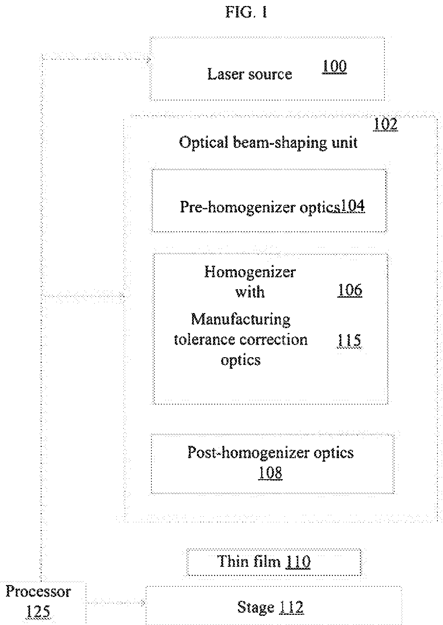

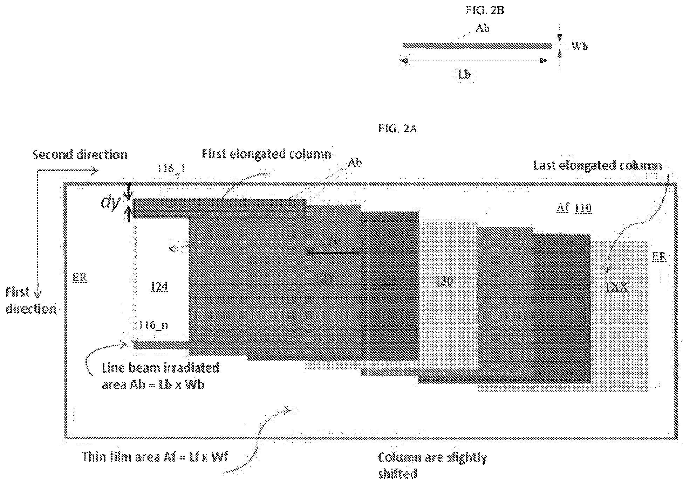

FIGs. 1 and 2 exemplify the inventive system incorporating a QCW fiber laser source 100 which outputs nanosecond (ns) bursts with burst duration varying between 50 and 500 ns. The burst regime is characterized by long pulses or bursts output at a burst repetition rate (BRR); each burst is partitioned into short pulses output at a carrier pulse repetition rate (PRR) in a 100 MHz to 1 GHz range which is, of course, higher than the BRR.

As typical for fiber lasers utilized in thin film processing, fiber laser source 100 includes one or more Yb QCW lasers each operating in a 1 micron range and outputting generally spatially and temporally coherent light which is necessary for effective generation of the second or third harmonic at respective 5xx nm and 3xx nm, such as 532 nm and 355 nm respectively, in a manner well known to the artisan. The coherence - so attractive a feature of the fiber laser - however, should be mitigated in order to obtain a fixed homogeneous line beam with a high aspect ratio.

The shaping of the laser beam takes place in an optical beam-shaping unit 102 that may include a pre-homogenizer optics 104, such as a power attenuator, collimator and in some instances - polarization controller. The heart of beam shaping unit 102 is a homogenizer 1 06 which is discussed in sufficient detail below. Meanwhile, the shaped laser beam is further guided by post-homogenizer optics 108, as will be discussed below.

As well understood by one of ordinary skill, homogenizer 106 may also function as a beam combiner for multiple fiber laser sources 100. Alternatively, multiple laser sources 100 are associated with respective optical schemes similar to the shown example, which deliver multiple line beams to the thin film surface.

The thin film 110 is supported on a stage 112 which can be displaced in first y and second x directions relative to laser source 100 and beam shaping unit 102. The relative displacement implies that either one of these components is movable while the other is stationary, or both components move relative to one another. Preferably, stage 112 is a multi-axis component operative to move in first (y) and second (x) directions. A single burst of individual homogenized beam irradiating thin film area Ab has the desired spatial intensity profiles in the first direction or second direction or first and second directions. Any of Gaussian, super Gaussian, or flat top profiles is applicable for the intended purposes.

FIGs. 2A - 2B illustrate the operational principle of the above discussed system. In particular, the following description relates to a 2D process in which film 110 is irradiated in the first Y and second X directions. It should be remembered that this invention discloses the fiber-based laser method of processing large area thin films is implemented with a small fiber laser beam. As a result, the partial film area Ab irradiated by the homogenized line beam is orders of magnitude smaller than the desired film area Af to be irradiated. The FLA process requires anywhere from 2 to 50 exposures per location, with a 10 - 30 exposures per location being typical for obtain a substantially uniformly dimensioned grains. The prior art dealt with these problems by continuously stitching consecutive irradiated film areas Ab in both SLS and FLA annealing. Unfortunately, the results hardly met the requirements for the quality of the processed film area Af. Particularly troubling results were received in the second scan direction X. The inventive method, however, allows for the overlap in both directions. The step size or distance dx in the second direction X is small to preclude the MURA phenomenon.

Referring to FIG. 2A, partial thin film area Ab 114 irradiated by the homogenized line beam may have a width Wb anywhere between 3 and 50 µm and a length Lb 500 -1000 and even more times greater than the width Wb. Turning to FIG. 2B, upon irradiating first partial thin film area Ab 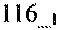 , stage 112 and beam-shaping unit 102 of FIG. 1 are sequentially displaced relative to one another at a distance dy to form a first column 124 in the first direction Y with area Ab 116n being the bottom irradiated area of first column 124. The distance dy may vary and is selected to prevent a thermal positive feedback between sequential irradiations above a predetermined threshold. The thermal positive feedback indicates that the temperature of a location within the overlapped film area is prohibitively high which indicates that a burst energy threshold was exceeded.

The minimal possible distance *dy* may be determined in the following manner. Assume that we form a first film area Ab, which is irradiated by an individual burst with a first burst energy Ebo = P_{laser source} /BRR. After analyzing the microstructure of the irradiated area Ab, one of ordinary skill can determine whether this area was heated too much, too low, or good. Assuming the latter and knowing the burst energy Ebo, the following area Ab is formed at a distance dy1 greater than the width Wb (FIG. 2B) of the area Ab. In other words, two adjacent areas Ab are spaced from one another, and the thermal conditions of respective first and second areas Ab are independent from one another. Having analyzed the second area Ab to ensure that the burst energy Ebo is indeed optimal or maximal, the operator selects a distance *dy*2 such that consecutively formed areas Ab overlap one another. If the overlapped area still has the desired microstructure, the distance *dy* is again reduced and a further burst forms a further area Ab overlapping a larger area of the first film area Ab. With a progressively smaller distance *dy,* the film within the overlapped area heats more and more. As a consequence, the burst energy Eb becomes progressively lower than the optimal burst energy Ebo. Once the burst energy Ebo is reduced to about 50% Ebo , which is the lowest possible energy sufficient to provide an acceptable quality of the FLA, the corresponding distance *dy* is considered to be smallest possible distance in the first direction Y and any further reduction of this distance can only lead to a prohibitively overheated overlapped film area. Thus, the drop of the optimal burst energy to 50% Ebo indicates the smallest possible *dy* distance and is further referred to as a step threshold.

As shown in FIG. 2B, this distance *dy* is less than the width Wb of the area Ab which provides the overlap between successive partial areas Ab of each of the formed columns. But this distance may also be equal to the width Wb. Furthermore, if the distance *dy* is selected to be greater than the width Wb, the adjacent areas Ab are spaced apart in the first direction Y. In this case, an intermediate un-irradiated area is formed between adjacent irradiated areas. The intermediate un-irradiated areas can be irradiated via a subsequent scan with the laser line beam provided the selected distance y does not correspond to the threshold.

After first column 124 is fully formed, stage 112 and beam shaping unit are displaced in the second direction X at a distance *dx*. Since the distance dx is shorter than the length of partial area Ab, corresponding partial areas Ab of respective adjacent columns overlap in the second direction X, as better shown in FIG. 2A. After the first area Ab of a second column 126 is formed, stage 112 and beam shaping unit 102 are displaced relative to one another in first direction Y to form subsequent partial areas Ab which define the second column 126. In use, the relative displacement in the first direction Y which is usually realized by stage 112, is continuous and does not exceed a few hundred millimeters per second. Such a velocity affects the alignment of partial areas Ab of respective columns 124, 126, 128 and 130 in the second direction X very little and can be easily tolerated. The process continues with a further formation of the desired number of columns 1XX. Whether the desired thin film area Af corresponds to the total area of film 110 or a panel supporting this film, or just a segment of the total area, the above disclosed process remains unchanged. To fully process the entire film area, the edges of the film spaced in the second direction X receive only a portion of the homogenized line beam. Typically, the edge areas ER have a width in the second direction X not exceeding the dx distance. Otherwise, the end regions of film 110 are not sufficiently heated and cooled to provide the desired film microstructure of these regions. All of the above operations are controlled by a processor 125.

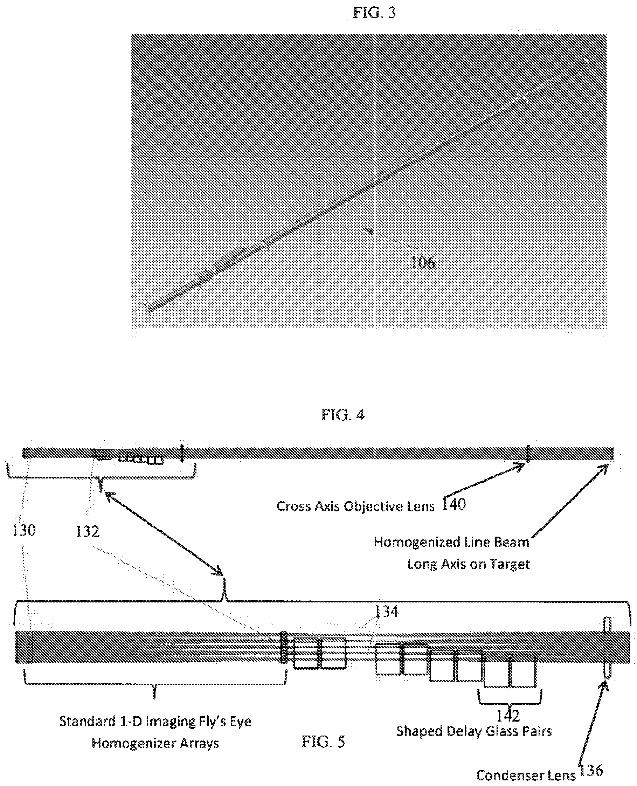

FIG. 3 illustrates homogenizer 106. Many beam homogenizers work on the same principle: the beam is divided into beamlets that are then superimposed on top of one another. Thus any of bi-prism, off-axis cylinder lens and other known configurations can in principle be incorporated in the disclosed system. The best experimental results have been obtained with imaging and nonimaging fly's eye homogenizers, with the imaging fly's eye configuration shown in FIGs. 3 - 5.

Referring to FIGs. 4 and 5, imaging fly's eye homogenizer 106 is configured with two spaced apart arrays of lenslets 130, 132 dividing, as known to the artisan, the laser beam into a plurality of beamlets 134. The beamlets are stretched in the second direction X and are merged on the surface of thin film 110 by condenser lens 136. However the beamlets may be somewhat offset in the first direction Y. To prevent the latter, the beamlets are guided through a cylindrical objective unit 140 focusing each stretched beamlet on the surface of film 110. As a result, the offset among the beamlets in the first direction is minimized. Furthermore, the objective unit 140 may comprise at least one acylindrical surface designed to provide a desired intensity profile in the narrow axis (Gaussian, super Gaussian, top hat.)

The relative position of condenser lens 136 and objective unit 140 is not fixed relative to one another. Thus although condenser lens 136 is shown before lens 140 in FIG. 4, the reverse position of these lenses is acceptable. Within the context of this disclosure, either one or both lenses 136 and 140 are considered to be part of post homogenizer optics 108 in FIG. 1.

Additionally, homogenizer 106 is configured with multiple delay glass pairs 142 located downstream from lenslets array 132. As known, delay glass pairs retard the stretched beamlets relative to one to even further mitigate any remaining coherence and constitute correction optics 115 of FIG. 1.

According to another salient feature of the invention, sequential delay glass shaped pairs 142 allow for the simultaneous mitigation of coherence effects and lenslet manufacturing tolerances, as explained below.

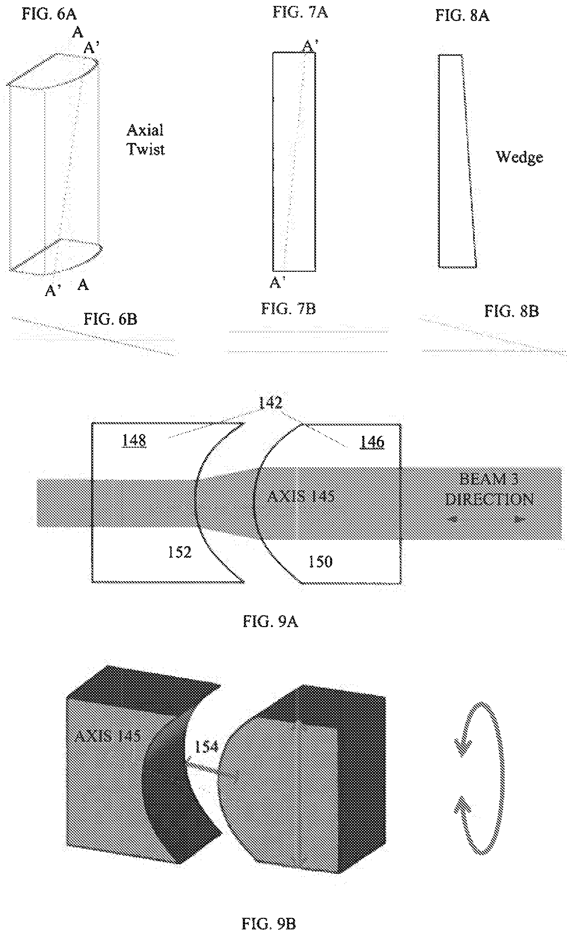

FIGs. 6A, 7A and 8A illustrate different manufacturing defects created during the production of lenslets and in principle other homogenizer components, such as delay glasses.

FIG. 6A and 7A illustrate axial twist which occurs when instead of ideal axis of symmetry A - A, the cylindrical lens is manufactured with skewed axis A' - A'. The axial twist rotates the line beamlets as shown in FIG. 6B. The lenses may be manufactured with a wedge - center thickness variation as shown in FIG. 8A. This defect shifts the line beam resulting in individual line beamlets being offset from each other, as shown in FIG. 7B. The presence of both axial twist and wedge defects results in simultaneous rotation and twist of beamlets relative one another on the surface of the thin film, as shown in FIG. 8B. All of these manufacturing defects can be corrected using individual delay glass pairs 142 configured in accordance with the invention.

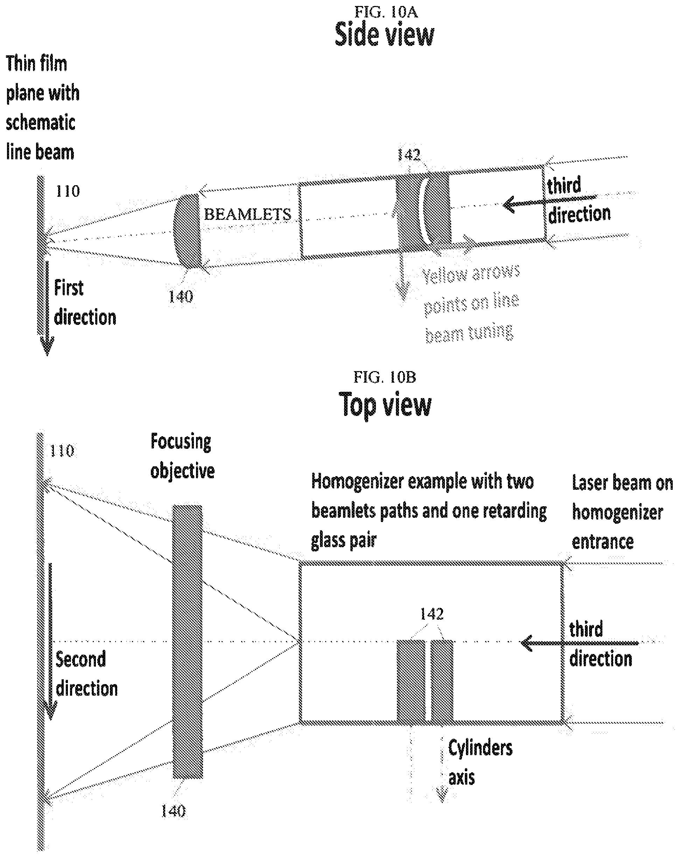

Referring to FIGs. 9A and 9B and 10A - 10B, as known, delay glass pair 142 includes positive and negative lenses 146, 148 provided with respective convex and concave faces 150, 152 which define therebetween a gap 154, with concave face 150 being somewhat smaller than that of convex face 152. Displacing lenses 146 and 148 toward and away from one another along common longitudinal axis 145 (FIG. 9A) ensures infinite conjugate with the gap 154. In other words, this linear displacement in along a beamlet path in a third direction (FIGs. 9A, 10A and B) helps focus the beamlets in a common focal plane on the surface of the film. The lenses 146 and 148 are also displaceable relative to one another in a in a direction perpendicular to both third and second directions. This displacement adjusts relative centration compensation for wedge tolerances. Finally, both lenses are configured to rotate relative to one another which compensates for axial twist tolerance (beam rotation). Adjusting centration and rotation simultaneously compensates for wedge and axial twist tolerances.

Delay glass pairs are installed and aligned sequentially, such that one beamlet of a pair of neighboring beamlets sees an increased total glass thickness (increased delay) and the beamlets are sequentially compensated for centration and axial twist. In other words, beginning with a lenslet located next to the side lenslet in each array, the number of delay glass pairs increases, as shown in FIGs. -3-5. Delay glass pairs may be installed with alternating concave/convex ordering to minimize changes in cross axis beamlet height. The combined function of the delay glass pairs allows for maximum use of the limited distance over which the individual beamlets remain separated.

Those skilled in the art will recognize that the foregoing embodiments are presented by way of example only and that within the scope of the appended claims; the invention may be practiced otherwise than as specifically described.

## Claims

1. A method of fiber laser processing of a thin film (110) deposited on a substrate, wherein a thin film area Af is defined by a width Wf and length Lf, comprising:
(a) providing a laser beam from at least one quasi-continuous wave (QCW) fiber laser source (100) operating in a burst regime;
(b) directing the laser beam through an optical beam-shaping unit (102) onto the thin film (110), thereby shaping the laser beam into a homogeneous line beam which irradiates a first thin film area Ab on a surface of the thin film (110), with the irradiated thin film area Ab corresponding to an individual burst and being a fraction of the thin film area Af, wherein the film area Ab is defined by a length Lb and width Wb;
(c) continuously displacing the optical beam-shaping unit (102) and the thin film (110) relative to one another in a first direction at a distance *dy,* wherein the *dy* distance is selected to prevent a thermal positive feedback between sequential irradiations above a predetermined *dy* threshold, thereby forming a sequence of uniform thin film areas Ab which along with the first thin film area Ab together define a first elongated column (124); and
(d) thereafter displacing the optical beam-shaping unit (102) and the substrate with the thin film (110) thereon relative to one another at a distance *dx* in a second direction transverse to the first direction and repeating steps (b) - (c), the distance dx being smaller than a length of the irradiated thin film area Ab, thereby forming a plurality of overlapped elongated columns on the thin film area Af, the *dx* and *dy* distances being so selected that that each location of the thin film area Af is exposed to the predetermined number of bursts ranging from 3 to 50, wherein directing the laser beam through the optical beam shaping unit (102) includes:
guiding the laser beam through an array of lenslets (130, 132), thereby splitting the laser beam into a plurality of beamlets (134) propagating in a third direction which is skewed to the first direction Y and orthogonal to the second direction,
temporarily retarding the beamlets (134) by guiding them through respective delay glass pairs (142), wherein the delay glass pairs (142) each are configured with spaced positive and negative cylinder lenses (146, 148) which have equal focal lengths and a common longitudinal axis extending in the third direction, the delay glass pairs (142) each being provided with respective curved faces (150, 152) opposing one another so as to define an axial gap (154) therebetween, wherein:
the optical beam-shaping unit (102) includes a homogenizer (106) operative to mitigate coherence of the laser beam; and
the temporarily retarding mitigates coherence effects and manufacturing tolerances of the homogenizer (106) to form the homogeneous line beam with a beam width equal to the Wb, ranging between 3 and 50 µm, and aspect ratio of 1 to 500, the temporarily retarding including:
(e) axially displacing the spaced positive and negative cylinder lenses (146, 148) of each delay glass pair (142) towards and away from one another along the third direction, thereby focusing the beamlets (134) in a common focal plane on the surface of the thin film (110),
(f) rotating the spaced positive and negative cylinder lenses (146, 148) of each delay glass pair (142) relative to one another about the common longitudinal axis which extends in the third direction,
(g) displacing the spaced positive and negative cylinder lenses (146, 148) relative to one another perpendicular to the common longitudinal axis and the second direction X, or
(h) a combination of the steps (e) through (g).

2. The method of claim 1, further comprising
placing increasing number of delay glass pairs (142) downstream from the cylindrical objective unit (140) beginning with a lenslet next to a side lenslet of the array and sequentially manipulating each of the delay glass pairs (142) to form the line beam.

3. The method of claim 1 or 2, wherein the QCW fiber laser source (100) operates with a duty cycle less than 100% so as to output the laser beam at a pulse repetition rate of at most 1 GHz, which is higher than a burst repetition rate and sufficient to generate a thermal response of the thin film (110) identical to that caused by the laser beam from the QCW fiber laser source (100) operating at 100% duty cycle.

4. The method of any of the previous claims, further comprising
generating and directing at least one additional laser beam on the thin film (110) so as to have desired spatial intensity profiles in the first direction or second direction or first and second directions; and/or
controlling polarization of the laser beam.

5. A fiber laser system for processing a thin film (110) deposited on a substrate comprising:
a stage (112) supporting the substrate;
at least one QCW fiber laser source (100) outputting bursts of a laser beam along a light path;
an optical beam shaping unit (102) configured to shape the laser beam into a homogeneous line beam which is incident onto a surface of the thin film (110) with desired geometrical dimensions, intensity profile, and an optimal power to form a first irradiated thin film area Ab which corresponds to a single burst and constitutes a fraction of a total thin film area Af to be processed, the thin film area Ab being defined by a length Lb and width Wb; and
a processor (125) configured to execute a series of steps comprising:
displacing the stage (112) and optical beam-shaping unit (102) relative to one another in the first direction at a distance dy so as to form a sequence of irradiated thin film areas Ab which cumulatively define a first elongated column (124) of predetermined length and width, the distance dy being selected to prevent a thermal positive feedback above a predetermined thermal threshold between sequential bursts,
displacing the stage (112) and optical beam-shaping unit (102) relative to one another in a second direction X orthogonal to the first direction Y at a distance dx,
displacing the stage (112) and optical beam-shaping unit (102) in the first direction to form a second column (126) defined by the sequence of irradiated thin film areas Ab and overlapping the first column (124), and
repeatedly and sequentially displacing the stage (112) and optical beam-shaping unit (102) in the first and second directions at respective distances dy and dx to form a plurality of overlapped columns on the thin film area Af until the total thin film area Af is processed, the dx and dy distances being so selected that that each location of the thin film area Af is exposed to the predetermined number of bursts ranging from 3 to 50,
wherein the optical beam-shaping unit (102) includes a homogenizer (106) operative to mitigate coherence of the laser beam,
the homogenizer (106) including one or more arrays of lenslets (130, 132) segmenting the laser beam into multiple beamlets (134) which propagate in a third direction skewed to the first direction and orthogonal to the second direction, further comprising
one or more arrays of delay glass pairs (142) located in respective paths of beamlets (134) and configured to compensate the homogenizer (106) manufacturing tolerances,
each delay glass pair (142) having a common elongated axis which extends in the third direction, and being configured with two axially spaced positive and negative cylinder lenses (146, 148) which are provided with respective convex and concave surfaces (150, 152) defining an axial gap (154) therebetween, wherein the positive and negative cylinder lenses (146, 148) of each delay glass pair (142) is
axially displaceable relative to one another so as to focus the plurality of beamlets (134) in a common focal plane on the surface of the thin film (110),
linearly displaceable relative to one another perpendicular to the longitudinal axis and second direction,
rotatable relative to one another about the elongated axis.

6. The fiber laser system of claim 5, wherein a number of delay glass pairs (142) is incrementally increased beginning with a next to the last lenslet of the array, the next to the last lenslet being associated with a single delay glass pair (142).

7. The fiber laser system of claim 5 or 6, wherein the homogenizer (106) further includes a cylinder lens arrangement (136) configured to recombine the beamlets (134) into the line beam on a surface of the thin film (110), the line beam being shaped with a high aspect ratio, wherein a 3 to 50 µm beam width corresponds to the width of the irradiated thin film area Ab.

8. The fiber laser system of any of claims 5 - 7, further comprising
a second or second and third harmonic generators upstream from the optical beam-shaping unit (102), and
at least one second QCW fiber laser source, the QCW fiber laser sources each being a single mode or multimode QCW fiber laser source outputting a train of nanosecond pulses at such a pulse repetition rate (PRR) that the shaped laser beam irradiates each location of the thin film area Af simultaneously, the PRR varying between 100 MHz and 1 GHz.

9. The fiber laser system of any of claims 5 - 8, further comprising an attenuator, a polarization controller and a collimator between the QCW fiber laser source (100) and the optical beam-shaping unit (102).

10. The fiber laser system of any of claims 5 - 9, wherein either the stage (112) or optical beam-shaping unit (102) or both are displaceable in the first and second directions, the dy distance being selected to be smaller than or equal to than a width of the irradiated thin film area Ab.

11. The fiber laser system of any of claims 5 - 10, further comprising
at least one second QCW burst fiber laser source having an output combinable with an output of the at least one first QCW fiber laser source (100) or delivered to the thin film (110) synchronously with the output of the at least one first QCW fiber laser source (100) through a designated optical beam-shaping unit which is configured analogously to the optical beam-shaping unit (102) processing the output of the at least one first QCW fiber laser source (100),
wherein the line beam has a desired intensity profile in both first and second directions and is selected from a Gaussian, super Gaussian or flat top profiles.

12. The fiber laser system of any of claims 5 - 11, wherein the at least one QCW fiber laser source (100) operating in the burst regime outputs a train of long pulses at a burst repetition rate (BRR), the long pulses each being partitioned into a train of short pulses at the PRR which is higher than the BRR; and/or
further comprising an acylindrical objective unit configured to shape an intensity profile of the line beam claim in the first direction into a Gaussian, Super-Gaussian or flat- top intensity profile.

## Patentansprüche

1. Verfahren für die Faserlaserbearbeitung eines Dünnfilms (110), der auf einem Substrat abgelagert ist, wobei der Filmbereich Af durch eine Breite Wf und eine Länge Lf definiert ist, wobei das Verfahren umfasst:
(a) Bereitstellen eines Laserstrahls von wenigstens einer Quasi-Dauerstrich-Faserlaserquelle (QCW-Faserlaserquelle) (100), die in einem Burst-Regime arbeitet;
(b) Lenken des Laserstrahls durch eine optische Strahlformungseinheit (102) auf den Dünnfilm (110), dadurch Formen des Laserstrahls zu einem homogenen Linienstrahl, der einen ersten Dünnfilmbereich Ab auf einer Oberfläche des Dünnfilms (110) bestrahlt, wobei der bestrahlte Dünnfilmbereich Ab einem einzelnen Burst entspricht und ein Bruchteil des Dünnfilmbereichs Af ist, wobei der Filmbereich Ab durch eine Länge Lb und eine Breite Wb definiert ist;
(c) ununterbrochenes Verschieben der optischen Strahlformungseinheit (102) und des Dünnfilms (110) relativ zueinander in einer ersten Richtung um eine Entfernung *dy,* wobei die Entfernung *dy* so gewählt wird, dass eine positive thermische Rückkopplung zwischen aufeinanderfolgenden Bestrahlungen über einen vorgegebenen dy-Schwellenwert verhindert wird, dadurch Bilden einer Folge gleichförmiger Dünnfilmbereiche Ab, die zusammen mit dem ersten Dünnfilmbereich Ab eine erste langgestreckte Kolonne (124) definieren; und
(d) danach Verschieben der optischen Strahlformungseinheit (102) und des Substrats mit dem Dünnfilm (110) darauf relativ zueinander um eine Entfernung *dx* in einer zweiten Richtung quer zu der ersten Richtung und Wiederholen der Schritte (b)-(c), wobei die Entfernung *dx* kleiner als eine Länge des bestrahlten Dünnfilmbereichs Ab ist, dadurch Bilden mehrerer überlappter langgestreckter Kolonnen auf dem Dünnfilmbereich Af, wobei die Entfernungen *dx* und *dy* so gewählt werden, dass jeder Ort des Dünnfilmbereichs Af der vorgegebenen Anzahl von Bursts im Bereich von 3 bis 50 ausgesetzt wird, wobei das Lenken des Laserstrahls durch die optische Strahlformungseinheit (102) enthält:
Führen des Laserstrahls durch eine Anordnung von Mikrolinsen (130, 132), dadurch Aufteilen des Laserstrahls in mehrere Mikrostrahlen (134), die sich in einer dritten Richtung fortpflanzen, die zu der ersten Richtung Y schief und zu der zweiten Richtung orthogonal ist,
zeitliches Verzögern der Mikrostrahlen (134) dadurch, dass sie durch jeweilige Verzögerungsglaspaare (142) geführt werden,
wobei die Verzögerungsglaspaare (142) jeweils mit beabstandeten positiven und negativen Zylinderlinsen (146, 148), die gleiche Brennweiten und eine gemeinsame Längsachse, die in der dritten Richtung verläuft, aufweisen, konfiguriert sind, wobei die Verzögerungsglaspaare (142) jeweils mit jeweiligen gekrümmten Flächen (150, 152), die einander gegenüberliegen, um dazwischen einen axialen Zwischenraum (154) zu definieren, versehen sind, wobei:
die optische Strahlformungseinheit (102) einen Homogenisierer (106), der dafür betreibbar ist, die Kohärenz des Laserstrahls zu mildern, enthält; und
das zeitliche Verzögern Kohärenzeffekte und Herstellungstoleranzen des Homogenisierers (106) mildert, um den homogenen Linienstrahl mit einer Strahlbreite gleich dem Wb, im Bereich zwischen 3 und 50 µm, und einem Seitenverhältnis von 1 zu 500 zu bilden, wobei das zeitliche Verzögern enthält:
(e) axiales Verschieben der beabstandeten positiven und negativen Zylinderlinsen (146, 148) jedes Verzögerungsglaspaars (142) aufeinander zu und voneinander weg entlang der dritten Richtung, dadurch Fokussieren der Mikrostrahlen (134) in einer gemeinsamen Brennebene auf der Oberfläche des Dünnfilms (110),
(f) Drehen der beabstandeten positiven und negativen Zylinderlinsen (146, 148) jedes Verzögerungsglaspaars (142) relativ zueinander um die gemeinsame Längsachse, die in der dritten Richtung verläuft,
(g) Verschieben der beabstandeten positiven und negativen Zylinderlinsen (146, 148) relativ zueinander senkrecht zu der gemeinsamen Längsachse und zu der zweiten Richtung X, oder
(h) eine Kombination der Schritte (e) bis (g).

2. Verfahren nach Anspruch 1, das ferner umfasst:
Platzieren einer zunehmenden Anzahl von Verzögerungsglaspaaren (142) auf der Ausgangsseite der zylindrischen Objektiveinheit (140), beginnend mit einer Mikrolinse neben einer seitlichen Mikrolinse der Anordnung, und aufeinanderfolgendes Manipulieren jedes der Verzögerungsglaspaare (142), um den Linienstrahl zu bilden.

3. Verfahren nach Anspruch 1 oder 2, wobei die QCW-Faserlaserquelle (100) mit einem Tastgrad kleiner als 100 % arbeitet, um den Laserstrahl mit einer Impulswiederholrate von höchstens 1 GHz auszugeben, die größer als eine Burst-Wiederholrate ist und ausreicht, eine Wärmereaktion des Dünnfilms (110) gleich der, die durch den Laserstrahl von der QCW-Faserlaserquelle (100), die bei einem Tastgrad von 100 % arbeitet, verursacht wird, zu erzeugen.

4. Verfahren nach einem der vorhergehenden Ansprüche, das ferner umfasst:
Erzeugen und Lenken wenigstens eines zusätzlichen Laserstrahls auf den Dünnfilm (110), um in der ersten Richtung oder in der zweiten Richtung oder in der ersten und in der zweiten Richtung gewünschte räumliche Intensitätsprofile zu haben; und/oder
Steuern der Polarisation des Laserstrahls.

5. Faserlasersystem zum Bearbeiten eines Dünnfilms (110), der auf einem Substrat abgelagert ist, wobei das Faserlasersystem umfasst:
eine Bühne (112), die das Substrat trägt;
wenigstens eine QCW-Faserlaserquelle (100), die entlang eines Lichtwegs Bursts eines Laserstrahls ausgibt;
eine optische Strahlformungseinheit (102), die dafür konfiguriert ist, den Laserstrahl zu einem homogenen Linienstrahl zu formen, der auf eine Oberfläche des Dünnfilms (110) mit gewünschten geometrischen Dimensionen, gewünschtem Intensitätsprofil und einer gewünschten optimalen Leistung auffällt, um einen ersten bestrahlten Dünnfilmbereich Ab, der einem einzelnen Burst entspricht und einen Bruchteil eines zu bearbeitenden Gesamtdünnfilmbereichs Af bildet, wobei der Dünnfilmbereich Ab mit einer Länge Lb und mit einer Breite Wb definiert ist, zu bilden; und
einen Prozessor (125), der dafür konfiguriert ist, eine Reihe von Schritten auszuführen, die umfassen:
Verschieben der Bühne (112) und der optischen Strahlformungseinheit (102) relativ zueinander in der ersten Richtung um eine Entfernung *dy,* um eine Folge bestrahlter Dünnfilmbereiche Ab zu bilden, die kumulativ eine erste langestreckte Kolonne (124) mit einer vorgegebenen Länge und Breite definieren, wobei die Entfernung *dy* so gewählt wird, dass eine positive thermische Rückkopplung über einen vorgegebenen thermischen Schwellenwert zwischen aufeinanderfolgenden Burst verhindert wird,
Verschieben der Bühne (112) und der optischen Strahlformungseinheit (102) relativ zueinander in einer zweiten Richtung X orthogonal zu der ersten Richtung Y um eine Entfernung *dx,*
Verschieben der Bühne (112) und der optischen Strahlformungseinheit (102) in der ersten Richtung zum Bilden einer zweiten Kolonne (126), die durch die Folge bestrahlter Dünnfilmbereiche Ab definiert ist und die erste Säule (124) überlappt, und
wiederholtes und aufeinanderfolgendes Verschieben der Bühne (112) und der optischen Strahlformungseinheit (102) in der ersten und in der zweiten Richtung über jeweilige Entfernungen *dy* und *dx,* um auf dem Dünnfilmbereich Af mehrere überlappte Kolonnen zu bilden, bis der gesamte Dünnfilmbereich Af bearbeitet ist, wobei die Entfernungen *dx* und *dy* so gewählt werden, dass jeder Ort des Dünnfilmbereichs Af der vorgegebenen Anzahl von Bursts in dem Bereich von 3 bis 50 ausgesetzt wird,
wobei die optische Strahlformungseinheit (102) einen Homogenisierer (106), der zum Mildern der Kohärenz des Laserstrahls betreibbar ist, enthält,
wobei der Homogenisierer (106) eine oder mehrere Anordnungen von Mikrolinsen (130, 132) enthält, die den Laserstrahl in mehrere Mikrostrahlen (134), die sich in einer dritten Richtung, die zu der ersten Richtung schief und zu der zweiten Richtung orthogonal ist, fortpflanzen, segmentieren, ferner umfassend:
eine oder mehrere Anordnungen von Verzögerungsglaspaaren (142), die sich in jeweiligen Wegen von Mikrostrahlen (134) befinden und dafür konfiguriert sind, Herstellungstoleranzen des Homogenisierers (106) zu kompensieren,
wobei jedes Verzögerungsglaspaar (142) eine gemeinsame Längsachse aufweist, die in der dritten Richtung verläuft und
mit zwei axial beabstandeten positiven und negativen Zylinderlinsen (146, 148) konfiguriert ist, die mit jeweiligen konvexen und konkaven Oberflächen (150, 152), die dazwischen einen axialen Zwischenraum (154) definieren, versehen sind, wobei die positiven und negativen Zylinderlinsen (146, 148) jedes Verzögerungsglaspaars (142):
relativ zueinander axial verschiebbar sind, um die mehreren Mikrostrahlen (134) in einer gemeinsamen Brennebene auf der Oberfläche des Dünnfilms (110) zu fokussieren,
relativ zueinander senkrecht zu der Längsachse und zu der zweiten Richtung linear verschiebbar sind,
um die Längsachse relativ zueinander drehbar sind.

6. Faserlasersystem nach Anspruch 5, wobei die Anzahl der Verzögerungsglaspaare (142), beginnend mit einer vorletzten Mikrolinse der Anordnung, inkrementell zunimmt, wobei der vorletzten Mikrolinse ein einzelnes Verzögerungsglaspaar (142) zugeordnet ist.

7. Faserlasersystem nach Anspruch 5 oder 6, wobei der Homogenisierer (106) ferner einen Zylinderlinsenaufbau (136) enthält, der zum Rekombinieren der Mikrostrahlen (134) zu einem Linienstrahl auf eine Oberfläche des Dünnfilms (110) konfiguriert ist, wobei der Linienstrahl mit einem hohen Seitenverhältnis geformt wird, wobei eine Strahlbreite von 3 bis 50 µm der Breite des bestrahlten Dünnfilmbereichs Ab entspricht.

8. Faserlasersystem nach einem der Ansprüche 5-7, das ferner umfasst:
Generatoren einer zweiten oder zweiten und dritten Harmonischen auf der Einlassseite der optischen Strahlformungseinheit (102), und
wenigstens eine zweite QCW-Faserlaserquelle, wobei die QCW-Faserlaserquelle jeweils eine Einmoden- oder Mehrmoden-QCW-Faserlaserquelle ist, die eine Folge von Nanosekundenimpulsen mit einer Impulswiederholrate (PRR) ausgibt, dass der geformte Laserstrahl jeden Ort des Dünnfilmbereichs Af gleichzeitig bestrahlt, wobei die PRR zwischen 100 MHz und 1 GHz variiert.

9. Faserlasersystem nach einem der Ansprüche 5-8, das ferner zwischen der QCW-Faserlaserquelle (100) und der optischen Strahlformungseinheit (102) ein Dämpfungsglied, einen Polarisationscontroller und einen Kollimator umfasst.

10. Faserlasersystem nach einem der Ansprüche 5-9, wobei entweder die Bühne (112) oder die optische Strahlformungseinheit (102) oder beide in der ersten und in der zweiten Richtung verschiebbar sind, wobei die Entfernung *dy* kleiner oder gleich einer Breite des bestrahlten Dünnfilmbereichs Ab gewählt wird.

11. Faserlasersystem nach einem der Ansprüche 5-10, das ferner umfasst:
wenigstens eine zweite QCW-Burst-Faserlaserquelle mit einer Ausgabe, die mit einer Ausgabe der wenigstens einen ersten QCW-Faserlaserquelle (100) kombinierbar ist oder synchron mit der Ausgabe der wenigstens einen ersten QCW-Faserlaserquelle (100) über eine bestimmte optische Strahlformungseinheit, die analog zu der optischen Strahlformungseinheit (102), die die Ausgabe der wenigstens einen ersten QCW-Faserlaserquelle (100) verarbeitet, konfiguriert ist, an den Dünnfilm (110) geliefert wird,
wobei der Linienstrahl sowohl in der ersten als auch in der zweiten Richtung ein gewünschtes Intensitätsprofil aufweist und aus einem Gauß-, einem Super-Gauß- oder einem Flat-Top-Profil gewählt wird.

12. Faserlasersystem nach einem der Ansprüche 5-11, wobei die wenigstens eine QCW-Faserlaserquelle (100), die in dem Burst-Regime arbeitet, eine Folge langer Impulse mit einer Burst-Wiederholrate (BRR) ausgibt, wobei die langen Impulse jeweils in eine Folge kurzer Impulse mit der PRR, die größer als die BRR ist, unterteilt sind; und/oder
das ferner eine azylindrische Objektiveinheit umfasst, die zum Formen eines Intensitätsprofils des Linienstrahls in der ersten Richtung in ein Gauß-, Super-Gauß- oder Flat-Top-Intensitätsprofil konfiguriert ist.

## Revendications

1. Procédé de traitement laser à fibre d'un film mince (110) déposé sur un substrat, dans lequel une zone de film mince Af est définie par une largeur Wf et une longueur Lf, comprenant :
(a) la fourniture d'un faisceau laser à partir d'au moins une source laser à fibre à onde quasi continue (QCW) (100) fonctionnant en mode rafale ;
(b) la direction du faisceau laser à travers une unité de mise en forme du faisceau optique (102) sur le film mince (110), mettant ainsi en forme le faisceau laser en un faisceau linéaire homogène qui irradie une première zone de film mince Ab sur une surface du film mince (110), la zone de film mince Ab irradiée correspondant à une rafale individuelle et représentant une fraction de la zone de film mince Af, la zone de film Ab étant définie par une longueur Lb et une largeur Wb ;
(c) le déplacement continu de l'unité de mise en forme du faisceau optique (102) et du film mince (110) l'un par rapport à l'autre dans une première direction à une distance *dy,* la distance *dy* étant choisie pour empêcher une rétroaction thermique positive entre des irradiations séquentielles au-dessus d'un seuil *dy* prédéterminé, formant ainsi une séquence de zones de film mince Ab uniformes qui, avec la première zone de film mince Ab, définissent ensemble une première colonne allongée (124) ; et
(d) le déplacement ultérieur de l'unité de mise en forme du faisceau optique (102) et du substrat avec le film mince (110) qui le recouvre l'un par rapport à l'autre à une distance *dx* dans une deuxième direction transversale à la première direction et la répétition des étapes (b) à (c), la distance dx étant inférieure à une longueur de la zone de film mince Ab irradiée, formant ainsi une pluralité de colonnes allongées superposées sur la zone de film mince Af, les distances *dx* et *dy* étant choisies de telle sorte que chaque emplacement de la zone de film mince Af soit exposé à un nombre prédéterminé de rafales allant de 3 à 50, la direction du faisceau laser à travers l'unité de mise en forme du faisceau optique (102) comprenant :
le guidage du faisceau laser à travers un réseau de lentilles (130, 132), divisant ainsi le faisceau laser en une pluralité de faisceaux secondaires (134) se propageant dans une troisième direction qui est inclinée par rapport à la première direction Y et orthogonale à la deuxième direction,
le retard temporaire des faisceaux (134) en les guidant à travers des paires de verres à retard (142) respectives, les paires de verres à retard (142) étant chacune configurées avec des lentilles cylindriques positives et négatives espacées (146, 148) qui ont des distances focales égales et un axe longitudinal commun s'étendant dans la troisième direction, les paires de verres à retard (142) étant chacune pourvues de faces courbes respectives (150, 152) opposées l'une à l'autre de manière à définir un espace axial (154) entre elles :
l'unité de mise en forme du faisceau optique (102) comprenant un homogénéisateur (106) servant à atténuer la cohérence du faisceau laser ; et
le retard temporaire atténuant les effets de cohérence et les tolérances de fabrication de l'homogénéisateur (106) afin de former le faisceau linéaire homogène avec une largeur de faisceau égale à Wb, comprise entre 3 et 50 µm, et un rapport d'aspect de 1 à 500, le retard temporaire comprenant :
(e) le déplacement axial des lentilles cylindriques positives et négatives espacées (146, 148) de chaque paire de verres à retard (142) l'une vers l'autre et l'une loin de l'autre le long de la troisième direction, focalisant ainsi les faisceaux (134) dans un plan focal commun sur la surface du film mince (110),
(f) la rotation des lentilles cylindriques positives et négatives espacées (146, 148) de chaque paire de verres à retard (142) l'une par rapport à l'autre autour de l'axe longitudinal commun qui s'étend dans la troisième direction,
(g) le déplacement des lentilles cylindriques positives et négatives espacées (146, 148) l'une par rapport à l'autre perpendiculairement à l'axe longitudinal commun et à la deuxième direction X, ou
(h) une combinaison des étapes (e) à (g).

2. Le procédé selon la revendication 1, comprenant en outre
le placement d'un nombre croissant de paires de verres à retard (142) en aval de l'unité d'objectif cylindrique (140), en commençant par une lentille située à côté d'une lentille latérale du réseau, et la manipulation séquentielle de chacune des paires de verres à retard (142) pour former le faisceau linéaire.

3. Le procédé selon la revendication 1 ou 2, dans lequel la source laser à fibre QCW (100) fonctionne avec un rapport cyclique inférieur à 100 % de manière à émettre le faisceau laser à une fréquence de répétition d'impulsions d'au plus 1 GHz, qui est supérieure à une fréquence de répétition de rafales et suffisante pour générer une réponse thermique du film mince (110) identique à celle provoquée par le faisceau laser provenant de la source laser à fibre QCW (100) fonctionnant à un rapport cyclique de 100 %.

4. Le procédé selon l'une des revendications précédentes, comprenant en outre
la génération et la direction d'au moins un faisceau laser supplémentaire sur le film mince (110) de manière à obtenir les profils d'intensité spatiale souhaités dans la première direction ou la deuxième direction ou les première et deuxième directions ; et/ou
le contrôle de la polarisation du faisceau laser.

5. Système laser à fibre pour traiter un film mince (110) déposé sur un substrat, comprenant :
un support (112) supportant le substrat ;
au moins une source laser à fibre QCW (100) émettant des rafales d'un faisceau laser le long d'un trajet lumineux ;
une unité de mise en forme du faisceau optique (102) configurée pour mettre en forme le faisceau laser en un faisceau linéaire homogène qui est incident sur une surface du film mince (110) avec des dimensions géométriques, un profil d'intensité et une puissance optimale souhaités pour former une première zone de film mince Ab irradiée qui correspond à une seule rafale et constitue une fraction d'une zone totale de film mince Af à traiter, la zone de film mince Ab étant définie par une longueur Lb et une largeur Wb ; et
un processeur (125) configuré pour exécuter une série d'étapes comprenant :
le déplacement du support (112) et de l'unité de mise en forme du faisceau optique (102) l'un par rapport à l'autre dans la première direction à une distance *dy* afin de former une séquence de zones de film mince Ab irradiées qui définissent de manière cumulée une première colonne allongée (124) de longueur et de largeur prédéterminées, la distance *dy* étant choisie pour empêcher une rétroaction thermique positive au-dessus d'un seuil thermique prédéterminé entre des rafales séquentielles, le déplacement du support (112) et de l'unité de mise en forme du faisceau optique (102) l'un par rapport à l'autre dans une deuxième direction X orthogonale à la première direction Y à une distance *dx*,
le déplacement du support (112) et de l'unité de mise en forme du faisceau optique (102) dans la première direction pour former une deuxième colonne (126) définie par la séquence de zones de film mince Ab irradiées et chevauchant la première colonne (124), et
le déplacement répété et séquentiel du support (112) et de l'unité de mise en forme du faisceau optique (102) dans les première et deuxième directions à des distances *dy* et *dx* respectives pour former une pluralité de colonnes superposées sur la zone de film mince Af jusqu'à ce que la zone totale de film mince Af soit traitée, les distances *dx* et *dy* étant choisies de telle sorte que chaque emplacement de la zone de film mince Af soit exposé à un nombre prédéterminé de rafales allant de 3 à 50,
l'unité de mise en forme du faisceau optique (102) comprenant un homogénéisateur (106) fonctionnant pour atténuer la cohérence du faisceau laser, l'homogénéisateur (106) incluant un ou plusieurs réseaux de lentilles (130, 132) segmentant le faisceau laser en plusieurs faisceaux secondaires (134) qui se propagent dans une troisième direction inclinée par rapport à la première direction et orthogonale à la deuxième direction, comprenant en outre
un ou plusieurs réseaux de paires de verres à retard (142) situés dans les chemins respectifs des faisceaux secondaires (134) et configurés pour compenser les tolérances de fabrication de l'homogénéisateur (106),
chaque paire de verres à retard (142) ayant un axe allongé commun qui s'étend dans la troisième direction, et étant configurée avec deux lentilles cylindriques positives et négatives (146, 148) espacées axialement et pourvues de surfaces convexes et concaves respectives (150, 152) définissant un espace axial (154) entre elles, les lentilles cylindriques positives et négatives (146, 148) de chaque paire de verres à retard (142) étant
déplaçables axialement l'une par rapport à l'autre de manière à focaliser la pluralité de faisceaux (134) dans un plan focal commun sur la surface du film mince (110), déplaçables linéairement l'une par rapport à l'autre perpendiculairement à l'axe longitudinal et à la deuxième direction,
pouvant tourner l'une par rapport à l'autre autour de l'axe longitudinal.

6. Le système laser à fibre selon la revendication 5, dans lequel un certain nombre de paires de verres à retard (142) sont augmentées de manière incrémentielle en commençant par l'avant-dernière lentille du réseau, l'avant-dernière lentille étant associée à une seule paire de verres à retard (142).

7. Le système laser à fibre selon la revendication 5 ou 6, dans lequel l'homogénéisateur (106) comprend en outre une disposition de lentilles cylindriques (136) configurée pour recombiner les faisceaux (134) en un faisceau linéaire sur une surface du film mince (110), le faisceau linéaire étant formé avec un rapport d'aspect élevé, une largeur de faisceau de 3 à 50 µm correspondant à la largeur de la zone de film mince Ab irradiée.

8. Le système laser à fibre selon l'une des revendications 5 à 7, comprenant en outre un générateur d'harmoniques de deuxième ou de deuxième et troisième ordre en amont de l'unité de mise en forme du faisceau optique (102), et
au moins une deuxième source laser à fibre QCW, les sources laser à fibre QCW étant chacune une source laser à fibre QCW monomode ou multimode émettant un train d'impulsions nanosecondes à une fréquence de répétition d'impulsions (PRR) de manière à ce que le faisceau laser mis en forme irradie simultanément chaque emplacement de la zone de film mince Af, la PRR variant entre 100 MHz et 1 GHz.

9. Le système laser à fibre selon l'une des revendications 5 à 8, comprenant en outre un atténuateur, un contrôleur de polarisation et un collimateur entre la source laser à fibre QCW (100) et l'unité de mise en forme du faisceau optique (102).

10. Le système laser à fibre selon l'une des revendications 5 à 9, dans lequel le support (112) ou l'unité de mise en forme du faisceau optique (102) ou bien les deux sont déplaçables dans les première et deuxième directions, la distance *dy* étant choisie pour être inférieure ou égale à la largeur de la zone de film mince Ab irradiée.

11. Le système laser à fibre selon l'une des revendications 5 à 10, comprenant en outre au moins une deuxième source laser à fibre QCW ayant une sortie pouvant être combinée avec une sortie de l'au moins une première source laser à fibre QCW (100) ou délivrée au film mince (110) de manière synchrone avec la sortie de l'au moins une première source laser à fibre QCW (100) par une unité de mise en forme de faisceau optique désignée, qui est configurée de manière analogue à l'unité de mise en forme de faisceau optique (102) traitant la sortie de l'au moins une première source laser à fibre QCW (100),
le faisceau linéaire ayant un profil d'intensité souhaité dans les première et deuxième directions et étant sélectionné parmi des profils gaussiens, super gaussiens ou à sommet plat.

12. Le système laser à fibre selon l'une des revendications 5 à 11, dans lequel l'au moins une source laser à fibre QCW (100) fonctionnant en mode rafale émet une série d'impulsions longues à une fréquence de répétition de rafale (BRR), les impulsions longues étant chacune divisées en une série d'impulsions courtes à la fréquence de répétition de pulsations (PRR) qui est supérieure à la fréquence de répétition de rafale (BRR) ; et/ou
comprenant en outre une unité d'objectif acylindrique configurée pour façonner un profil d'intensité du faisceau linéaire dans la première direction en un profil d'intensité gaussien, super-gaussien ou à sommet plat.
